# EUROPÄISCHE PATENTSCHRIFT

(11) **EP 1 508 164 B1**
(45) Veröffentlichungstag und Bekanntmachung des Hinweises auf die Patenterteilung: **10.07.2019**
(21) Anmeldenummer: 03720479.9
(22) Anmeldetag: 16.04.2003
(51) Int. Cl.: H01L 21/28, H01L 21/338, H01L 21/285, H01L 29/423, H01L 29/66

(54) **VERFAHREN ZUR HERSTELLUNG EINES HALBLEITERBAUELEMENTES UND DANACH HERGESTELLTES HALBLEITERBAULELEMENT**
METHOD FOR PRODUCING A SEMICONDUCTOR COMPONENT, AND SEMICONDUCTOR COMPONENT PRODUCED BY THE SAME
PROCEDE DE PRODUCTION D'UN COMPOSANT SEMI-CONDUCTEUR ET COMPOSANT SEMI-CONDUCTEUR AINSI PRODUIT

(30) Priorität: 11.05.2002 DE 10220999; 06.02.2003 DE 10304722
(43) Veröffentlichungstag der Anmeldung: 23.02.2005
(73) Patentinhaber: United Monolithic Semiconductors GmbH, 89081 Ulm (DE)
(72) Erfinder: BEHAMMER, Dag, 89079 Ulm (DE)
(74) Vertreter: Baur & Weber Patentanwälte PartG mbB
(86) Internationale Anmeldenummer: PCT/EP2003/003979
(87) Internationale Veröffentlichungsnummer: WO 2003/096399

(56) Entgegenhaltungen:
- EP-A- 0 370 428
- EP-A- 0 591 608
- DE-A- 4 334 427
- DE-A- 19 533 291
- JP-A- 7 086 589
- US-A- 5 155 053
- US-A- 5 960 269
- US-A1- 2001 022 643
- US-B1- 6 294 802

## Beschreibung

Die Erfindung betrifft ein Verfahren zur Herstellung eines Halbleiterbauelements sowie ein insbesondere nach einem solchen Verfahren hergestelltes Halbleiterbauelement.

Bei der Herstellung von Halbleiterbauelementen, insbesondere Feldeffekttransistoren in Verbindungshalbleitermaterialien wird häufig eine Elektrode, insbesondere eine Transistor-Gateelektrode mit einem schmalen Elektrodenfluß von teilweise < 300 nm und einem demgegenüber breiteren, typischerweise wenigstens doppelt so breiten Elektrodenkopf, auf einem Halbleiterbereich erzeugt, wobei häufig in dem Halbleiterbereich ein Recess-Graben eingeätzt wird. Je nach Vorgehensweise bei der Erzeugung der metallischen Elektrode weist diese eine Form auf, welche als T-Form, Y-Form, A-Form oder mit einer gewölbten Unterseite auch als Champagnerglas-Form bezeichnet wird.

In der US 5 155 053 ist ein Verfahren zur Herstellung einer derartigen metallischen Elektrode beschrieben, bei welcher in einer Deckschicht eine Öffnung mit der Struktur des Elektrodenfußes erzeugt wird. Durch Trockenätzung wird in einer Polymerschicht unter der Öffnung die Form des Elektrodenkopfes erzeugt und die Struktur der Öffnung als Struktur des Elektrodenfußes bis zu dem Halbleiterbereich fortgesetzt. Nach Entfernen der Deckschicht wird das Elektrodenmetall ganzflächig auf die Polymerschicht und in die freigelegte Struktur für die Elektrode abgeschieden. Das auf die Polymerschicht abgeschiedene Metall wird durch einen Lift-off-Prozess zusammen mit der Polymerschicht entfernt. Die Vorgehensweise ist einfach und hinsichtlich der selbstjustierenden Ausrichtung von Elektrodenkopf und Elektrodenfuß vorteilhaft. Nachteilig sein kann, insbesondere bei Verwendung von Aluminium für die metallische Elektrode, die Partikelbildung bei der Metallabscheidung, welche insbesondere auch zu ungleichmäßigen Kanten der Metallschicht auf der Polymerschicht und damit zu ungleichmäßiger Form der Elektrode führen kann, sowie die Lift-off-Prozedur mit eventuellen Rückständen.

In der US 5 960 269 wird die Gatemetallisierung in zwei Schritten gebildet. Zunächst wird ein Spacer an den Innenseiten des aus Recess und SiN-Maske gebildeten Grabens erzeugt. Nach der Metallverfüllung werden durch eine Planarisierung und Rückätzung selbstjustiert die Source-, Drain- und Gate Kontaktgebiete ausgebildet. Anschließend wird die niederohmige Metallisierung aufgebracht. Die Y-Form im Gatefußbereich ergibt sich durch die Form der Spacer. Nachteil dieses Verfahrens ist die Spacerätzung auf dem offenen Recess, die Verwendung eines lift-off Verfahrens zur Gatekopfmetallisierung und die zunächst große Rückkoppelkapazität vom Gate zu Source und Drain, solange das Dielektrikum vollständig unter dem Gatekopf erhalten bleibt. Durch die ebenfalls gezeigte Benutzung verschiedener Hilfsschichten, die nach der Gatekopfdefinition teilweise wieder entfernt werden, lässt sich diese Rückkoppelkapazität reduzieren.

In EP0 370 428 werden unter Zuhilfenahme eines Mehrlagenlacksystems Gatefuß und Gatekopf selbstjustierend zueinander definiert. Dabei wird durch Einsatz einer isotropen Ätzung eine anorganische Maskierungsschicht so unterätzt, dass eine negative Profilform entsteht. Die Unterätzung legt die Größe des Gatekopfes fest. Anschließend maskiert die Maskierungsschicht die Ätzung der Stopschicht zwischen den Polymerschichten und des Gatefusses. Durch die Entfernung der Maskierungsschicht wird die Gatekopfmaskierung freigelegt, das Gatemetall aufgedampft und anschließend geliftet. Hauptproblem der beschriebenen Lösung bleibt der Einsatz eines lift-off Prozesses für die Gatedefinition.

Nachteilig an der Lift-off-Technik ist allgemein, dass bei der Abscheidung von Elektrodenmetall für den Elektrodenkopf in eine abgesenkte Öffnung ungleichmäßige und/oder mechanisch instabile Bereiche des Elektrodenkopfes entstehen können, vor allem dann, wenn durch den Elektrodenfuß eine weitere Stufe entsteht. Durch seitliches Zuwachsen der Öffnung, durch welche das Elektrodenmetall abgeschieden wird, ergibt sich typischerweise eine Verjüngung des Elektrodenkopfes nach oben.

Die US 6 294 802 B1 beschreibt ein Verfahren zur Herstellung eines Feldeffekttransistors, bei welchem eine T-förmige Gateelektrode mit dem Gatefuß in einem in einer Halbleiterschichtenfolge eingebrachten Recess angeordnet ist und die Oberfläche der Gateelektrode und der diese umgebenden Halbleiterschichten einschließlich eines von Gateelektrode und Recess mehrseitig begrenzten Raums durch eine Passivierungsschicht bedeckt ist. Die DE 43 34 427 A1 beschreibt die Herstellung eines Feldeffekttransistors mit in einem Recess abgesenkten Gate auf, welches durch selektives Entfernen einer zuvor ganzflächig abgeschiedenen Metallschicht strukturiert wird. Auch hier wird eine Passivierungsschicht auf der Oberfläche der Gateelektrode und der diese umgebenden Halbleiterschichten abgeschieden.

In der DE 195 33 291 A wird zusätzlich auf nachfolgend bis zur Fertigstellung eines Bauelements abgeschiedene Materialien und deren Einfluss auf das Hochfrequenzverhalten eingegangen und vorgeschlagen, auf der Passivierungsschicht über der Gateelektrode und seitlich von dieser eine Umhüllungsschicht aus fluorhaltigem Harz mit niedriger Dielektrizitätskonstante abzuscheiden.

In der JP 07-086589 A wird zur Reduzierung der parasitären Kapazitäten eines MOS-Transistors vorgeschlagen, einen Raum zwischen T-förmiger Gateelektrode gasgefüllt zu oder evakuiert belassen. Hierfür wird nach Erzeugen der der Gateelektrode genannte Raum als Hohlraum erzeugt und mit einer über der Gateelektrode und seitlich von dieser abgeschiedenen dielektrischen Schicht verschlossen, ohne dass der Hohlraum mit dem Material dieser dielektrischen Schicht gefüllt wird. Auf der den Hohlraum begrenzenden Halbleiterschicht kann eine weitere dielektrische dünne Schicht vorliegen. Durch die niedrige Dielektrizitätskonstante des Gases in dem dauerhaft verschlossenen Hohlraum können parasitäre Kapazitäten zwischen Gateelektrode und Source-/Drain-Elektroden niedrig gehalten werden.

Der vorliegenden Erfindung liegt die Aufgabe zugrunde, ein vorteilhaftes Verfahren zur Herstellung eines Halbleiterbauelements mit einer in einem Recess-Graben angeordneten Elektrode und einem gasgefüllten Hohlraum unter dieser Elektrode anzugeben.

Eine erfindungsgemäße Lösung ist in dem unabhängigen Anspruch 1 beschrieben. Die abhängigen Ansprüche enthalten vorteilhafte Ausgestaltungen der Erfindung. Die Erfindung ist nachfolgend anhand der Erzeugung einer bevorzugt T-förmigen Gateelektrode eines Feldeffekttransistors näher erläutert, ohne hierauf beschränkt zu sein.

Die Abscheidung einer ganzflächig durchgehenden Metallschicht auf einer Schutzschicht über der Oberfläche des Halbleitermaterials einschließlich der für den Gatefuß in der Schutzschicht geätzten Öffnung mit Recess-Unterätzung führt zu einer gleichmäßigen Metallschicht präzis einstellbarer Dicke. Die nachfolgende Ätzung der Struktur des Elektrodenkopfes in dieser durchgehenden Metallschicht ergibt eine Querschnittform des Gatekopfes mit glatten Seitenflanken und präzis einstellbarer Breite. Zusätzlich kann über die Parameter des Ätzschrittes auch eine definierte Neigung der Seitenflanken, insbesondere auch in Form einer Verjüngung des Gatekopfes von oben zum Gatefuß hin erzielt werden.

Die Abscheidung einer ganzflächig durchgehenden Metallschicht mit nachfolgender Ätzung des Gatekopfes ist insbesondere in Verbindung mit der Verwendung von Aluminium für das metallische Gate von Vorteil, da die durchgehende Schicht mit hoher Homogenität abgeschieden wird und Aluminium präzis und leicht, insbesondere in einem CI-Plasma anisotrop strukturiert werden kann. Der Gatefaden des Transistors kann dadurch über die gesamte Länge präzise strukturiert werden im Unterschied zu der Unregelmäßigkeit von AI-Leiterbahnen durch das für Aluminium typische Zuwachsen der Öffnung in der Maskierungsschicht bei Lift-off-Prozessen.

Die vorzugsweise in einem frühen Stadium des Herstellungsverfahrens für das Bauelement aufgebrachte Schutzschicht wird selektiv zu Halbleitermaterial und Gatemetall aufgelöst. Die dabei freigelegte Halbleiteroberfläche des Recess-Grabens um den Gatefuß wird mit einer Passivierungsschicht versehen, welche für die Langzeitstabilität der Eigenschaften des Bauelementes wesentlich ist. Darüber hinaus schützt die Passivierungsschicht die Halbleiteroberfläche des Recess-Bereichs bei nachfolgenden Schritten des Herstellungsverfahrens für das Bauelement. Die Passivierungsschicht kann vorteilhafterweise ein Nitrid, insbesondere Si₃N₄ enthalten Die Passivierungsschicht wird vorteilhafterweise auch auf dem Gatemetall abgeschieden, wodurch insbesondere bei Einsatz von Aluminium für das Metallgate eine unkontrollierte Oxidation der Metalloberfläche vermieden werden kann.

Die Schutzschicht kann aus verschiedenen für die Schutzfunktion der Halbleiteroberfläche und darauf vorzugsweise bereits erzeugter Kontakte für Source und Drain des Transistors geeigneten Materialien, zu welchen auch Lackschichten zählen, bestehen. Besonders vorteilhaft ist eine Schutzschicht aus Nitrid, insbesondere Si₃N₄, deren Dicke mit hoher Präzision einstellbar ist, so dass der vertikale Abstand der Unterseite des Gatekopfes von der Halbleiteroberfläche im Recess-Graben und gegebenenfalls seitlich von diesem genau und reproduzierbar eingestellt werden kann. Dieser Abstand ist von besonderer Bedeutung für die parasitäre Kapazität zwischen Source und Gate und zwischen Gate und Drain eines Feldeffekttransistors.

Diese parasitären Kapazitäten können vorteilhafterweise dadurch verringert werden, dass der von Halbleiteroberfläche des Recess-Grabens, von Gatefuß und von Unterseite des Gatekopfes mehrseitig umschlossene Hohlraum, welcher nach dem Entfernen der Schutzschicht zu einer dem Gatefuß abgewandten Seite offen ist, nicht vollständig mit dem Material der Passivierungsschicht aufgefüllt, aber auch nicht ungefüllt offengelassen wird, sondern definiert mit einem Dielektrikum niedriger Dielektrizitätskonstante dauerhaft ausgefüllt wird.

Beispielsweise kann gemäß einer vorteilhaften Ausführungsform die Passivierungsschicht, welche wegen der engen Zugangsöffnung zu dem Hohlraum in diesem typischerweise langsamer aufwächst als außerhalb des Hohlraums, so lange bzw. in einem solchen Umfang abgeschieden wird, dass die Öffnung durch die Passivierungsschicht abgeschlossen wird, ohne dass der Hohlraum vollständig mit Passivierungsmaterial gefüllt ist. Der Hohlraum bleibt dann auf Dauer gasgefüllt, wodurch die parasitäre Kapazität gering gehalten wird.

In anderer vorteilhafter Ausführung wird die Passivierungsschicht nur mit geringer Schichtdicke und insbesondere unter Freihaltung einer Zugangsöffnung zu dem Hohlraum abgeschieden. Der verbleibende Hohlraum wird mit einem Dielektrikum niedriger Dielektrizitätskonstante ε, insbesondere ε<3,0, gefüllt, welches dauerhaft in dem Hohlraum verbleibt. Ein solches Dielektrikum kann insbesondere in einem flüssigen Zustand eingebracht und danach verfestigt werden. Als Dielektrikum ist insbesondere BCB (Benzocyclobuten) geeignet. Außerhalb des Hohlraums befindliches Dielektrikum kann auf je nach Material geeignete Weise entfernt werden, wobei ein Angriff des eingesetzten Mittels auf das im Hohlraum befindliche Dielektrikum so weit beschränkt werden kann, dass dieses bis zur Entfernung des außerhalb des Hohlraums befindlichen Dielektrikums nur im Bereich der Hohlraumöffnung abgetragen wird. Die gezielte Ausfüllung des Hohlraums mit einem definierten festen Dielektrikum niedriger Dielektrizitätskonstante vermeidet zuverlässig, dass in nachfolgenden Prozessschritten Substanzen, welche im Regelfall auch höhere Dielektrizitätskonstanten aufweisen, unkontrolliert in dem Hohlraum abgeschieden werden.

Die Passivierungsschicht, welche auch aus mehreren verschiedenen Materialien zusammengesetzt sein und/oder in aufeinanderfolgenden Teilschichten abgeschieden werden kann, kann vorteilhafterweise in einem CVD (chemical vapour deposition)-Verfahren, insbesondere auch plasmaunterstützt (plasma enhanced, PECVD) abgeschieden werden.

Die Geometrien von Halbleiteroberfläche, Gatefuß und Gatekopf sind vorzugsweise so eingestellt, dass der sich nach Entfernen der Schutzschicht ergebende Hohlraum vom Elektrodenfuß beabstandet eine minimale Distanz zwischen Elektrodenkopf und Halbleiteroberfläche als Öffnung aufweist, deren Öffnungsweite vorzugsweise geringer als die maximale vertikale und oder horizontale Erstreckung des Hohlraums ist. Die Dimensionen des Gatekopfes in diesem Sinne können hinsichtlich der unteren Breite des Gatekopfes dadurch gegenüber dem reinen Metallgate vergrößert werden, das vor Entfernen der Schutzschicht an den geätzten Flanken des Elektrodenkopfes seitliche Zusatzschichten (spacer) abgeschieden werden, welche auf Dauer an den Seitenflanken verbleiben und insbesondere auch von der Passivierungsschicht bedeckt werden können. Solche seitlichen Zusatzschichten können insbesondere in Verbindung mit einem sich nach unten verjüngenden metallischen Gatekopf kombiniert werden, wodurch sich durch die verkleinerte metallische Unterseite einerseits und die zuverlässige Hohlraumbildung unter Metall und seitlichen Zusatzschichten des Gatekopfes andererseits besonders geringe parasitäre Kapazitäten ergeben. Vorzugsweise besitzt der Gatekopf um den Gatefuß eine untere Fläche, welche parallel zu den Schichtenebenen der Halbleiterschichten verläuft. Bei einer solchen bevorzugten Struktur sind die Kapazitäten zwischen Gate und Source bzw. Drain eines Feldeffekttransistors besonders kritisch.

Gemäß einer bevorzugten Ausführungsform kann die Struktur der Öffnung für den Elektrodenfuß mittels eines an einer Seitenflanke einer Hilfschicht abgeschiedenen Spacers definiert werden. Die an sich bekannte Spacer-Technik ermöglicht eine besonders präzise Einstellung der Breite des Gatefusses für sehr kleine Gatelängen.

Die erfindungswesentlichen Verfahrensschritte können vorteilhafterweise auf einen die Herstellung der Gateelektrode betreffenden Verfahrensabschnitt konzentriert werden, so dass bei dem übrigen Verfahrensablauf weitgehend die gebräuchlichen und bewährten Verfahrensschritte unverändert übernommen werden können.

Die Erfindung ist nachfolgend anhand bevorzugter Beispiele unter Bezugnahme auf die Abbildungen noch eingehend veranschaulicht. Dabei zeigt
- Fig. 1: mehrere Schritte eines Verfahrens zur Herstellung eines Bauelements nach der Erfindung,
- Fig. 2: Ausschnittsvergrößerungen zur Herstellung einer metallischen Gateelektrode,
- Fig. 3: die Herstellung eines verbreiterten Gatekopfes,
- Fig. 4: eine alternative Ausführung zu Fig. 3,
- Fig. 5: eine Ausführung mit gezielt ausgefülltem Hohlraum.
- Fig. 6: die Erzeugung einer Struktur eines Elektrodenfußes

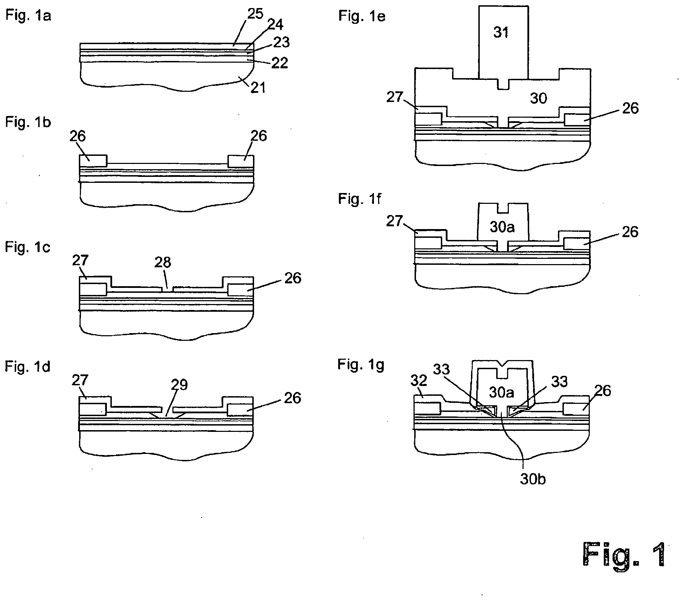

In Fig. 1 ist die Herstellung eines HEMT (high electron mobility transistor) auf GaAs-Verbindungshalbleitermaterial in mehreren Schritten skizziert. Ausgehend von dem GaAs Substrat 21 definieren die Schichten 22-25 das Vertikalprofil des Transistors, das in seiner Dicken- und Elementstruktur von der Anwendung stark abhängig ist. Grundsätzlich stellt 22 den Buffer dar, 23 bildet das zweidimensionale Elektronengas (Kanal), 24 ist eine Stopschicht, die zur definierten Ätzung des Recess-Grabens beiträgt, und 25 die hochdotierte Kontaktschicht (Fig. 1a). Nach Definition der ohmschen Kontakte 26 für Source und Drain in Fig. 1b erfolgt die PECVD-Abscheidung der Si₃N₄-Schicht 27 als Schutzschicht, in die eine Öffnung 28 mit der Struktur des Gatefußes geätzt wird (Fig. 1c). Anschließend erfolgt wie in Fig. 1d dargestellt eine naß- oder trockenchemische Ätzung zur Strukturierung des Recess-Grabens 29 durch Unterätzung der Öffnung 28 in der Kontaktschicht 25 und die ganzflächige Abscheidung des Gatemetalls 30. Dies besteht in vorteilhafter Ausführung überwiegend aus gedampften oder gesputtertem AI mit einer Haftschicht und einer Deckschicht z. B. aus Titan. Je nach Anwendung können auch zusätzliche Diffusionsbarrieren wie TaN, WTi oder TiN aufgebracht werden, die jedoch vorzugsweise trockenchemisch strukturierbar sein sollten. Eine nachfolgende Strukturierung des Gatemetalls 30 zur Erzeugung des metallischen Gatekopfes wird durch den Fotolack 31 maskiert (Fig. 1e), so dass nach Entfernung des Lackes die Struktur 30a als metallischer Gatekopf entsteht (Fig. 1f). Der Gatefuß ist mit 30b bezeichnet. Anschließend wird die Schutzschicht 27 vorzugsweise trockenchemisch in einem fluorhaltigen Plasma (CF₄/O₂, SF₆/O₂)entfernt. Nachfolgend wird die gesamte Anordnung mit einer Passivierungsschicht 32 bedeckt. Durch die überhängende Gatestruktur entstehen Hohlräume 33 (Fig. 1g), die die Rückkoppelkapazität zwischen Gate und Source und Drain reduzieren.

Die Form der Gate-Elektrode mit einer zu den Halbleiterschichtebenen parallelen Unterseite des Gatekopfes ist besonders vorteilhaft. Diese Form entsteht durch Abscheiden des Gatemetalls auf einer die Halbleiterschichten um den Gatefuß abdeckenden Schicht oder Schichtenfolge mit in diesem Bereich ebener Oberfläche, wogegen bei der Y-oder Champagnerglasform die Unterseite primär durch gerundete seitliche Flanken eine Umgebungsschicht bestimmt ist.

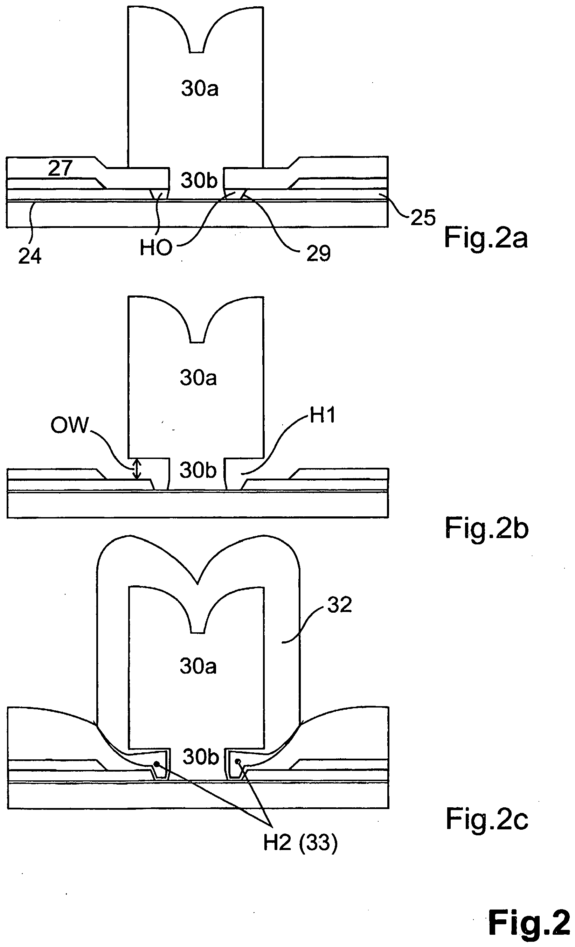

In Fig. 2a bis 2c ist der Verfahrensabschnitt nach Ätzen des Gatekopfes 30a entsprechend Fig. 1f vergrößert dargestellt. Die Abmessungen sind nicht als maßstabsgetreu zu betrachten. In dem geätzten Recess-Graben besteht zwischen Gatefuß 30b, Recess-Graben 29 und Schutzschicht 27 ein Hohlraum 40, in welchem aber die Halbleiteroberfläche des Recess-Grabens freiliegt. Die Schutzschicht 27 wird wie beschrieben entfernt, so dass in Fig. 2 zwischen Gatekopf 30a, Gatefuß 30b und Halbleiteroberfläche des Recess-Grabens 29 ein Hohlraum H1 vorliegt, der auf seiner dem Gatefuß abgewandten Seite eine Öffnung mit einer minimalen Öffnungsweite OW aufweist. Die Öffnungsweite OW ist vorzugsweise geringer als die maximale Erstreckung des Hohlraums parallel und senkrecht zu den Halbleiterschichten.

Eine aus der Gasphase, insbesondere nach PECVD abgeschiedene Passivierungsschicht 32 schlägt sich außerhalb und innerhalb des Hohlraums H1 nieder, wobei das Schichtwachstum im Hohlraum H1 wegen der geringen Öffnungsweite OW deutlich schwächer ist als außerhalb des Hohlraums und durch das Zuwachsen der Öffnung auch schnell weiter abnimmt. Die Passivierungsschicht wird so lange bzw. in einem solchen Umfang abgeschieden, dass die Passivierungsschicht am Eingang zum Hohlraum von zwei Seiten zusammenwächst und einen abgeschlossenen verkleinerten Hohlraum H2 bildet, welcher dauerhaft verschlossen und gasgefüllt bleibt.

Die Passivierungsschicht 15 in Fig. 2c kann auch aus verschiedenen Materialien, die beispielsweise in Teilschichten nacheinander abgeschieden werden, aufgebaut sein. Vorzugsweise wird als das zuerst abgeschiedene Material Nitrid gewählt.

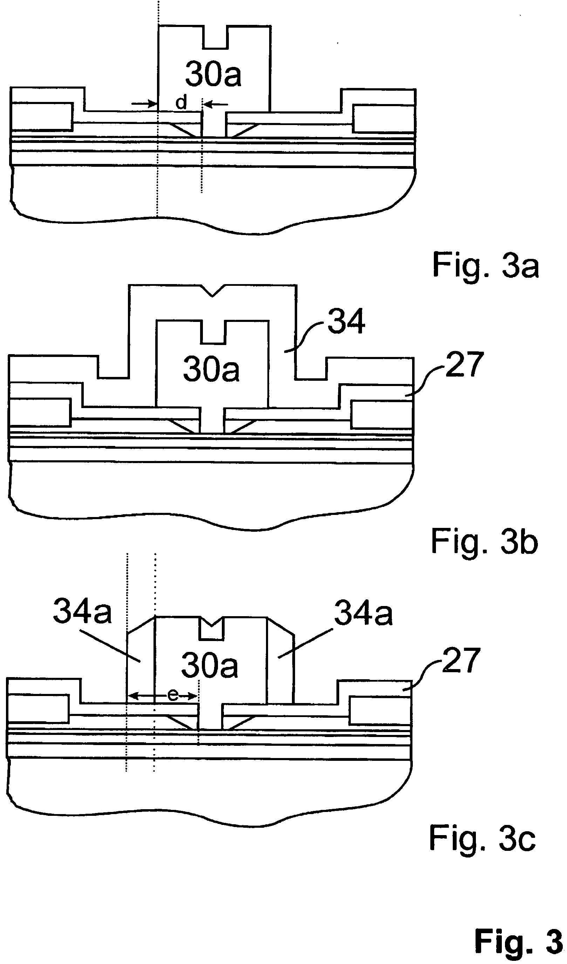

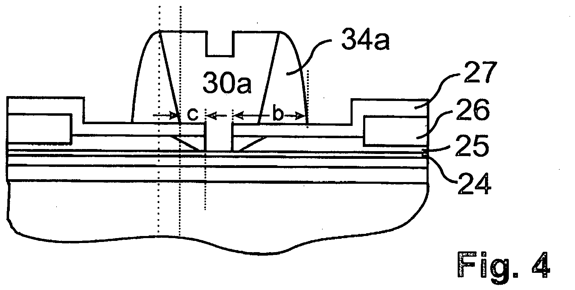

In Fig. 3 ist in Weiterbildung der Erfindung ein zusätzlicher Verfahrensabschnitt zwischen der Ätzung des metallischen Gatekopfes (Fig. 3a, Fig. 1f, Fig. 2a) und der Entfernung der Schutzschicht 27 vorgesehen, indem nach der Ätzung des Gatekopfes an dessen Seitenflanken dielektrische Zusatzschichten, z B. nach Art von sogenannten Spacern erzeugt werden, welche die horizontale Erstreckung der Unterseite des derart verbreiterten Gatekopfes von dem Maß d nach Fig. 3a auf das Maß e in Fig. 3c vergrößern. Hierfür kann eine ganzflächig aufgebrachte Schicht 34 in Fig. 3b, z. B. eine Oxidschicht, durch anisotropes Ätzen wie von Verfahren zur Herstellung von Spacern bekannt, bis auf Restschichten 34a an steilen Seitenflanken abgetragen werden. Durch die große Tiefe e des nach Entfernen der Schutzschicht 27 unter dem Gatekopf entstehenden Hohlraums H1 wird in diesem die Passivierungsschicht 15 nur in geringer Dicke abgeschieden, so dass ein großer Hohlraum H2 verbleibt und entsprechend die parasitären Kapazitäten klein bleiben. Das Aufwachsen der seitlichen Zusatzschichten ist insbesondere von Vorteil für eine Form des metallischen Gatekopfes, welche durch entsprechende Einstellung von Ätzparametern bei der Ätzung des metallischen Gatekopfes aus der durchgehenden Metallschicht 30 eine Verjüngung des metallischen Gatekopfes nach unten, d. h. zum Gatefuß hin zeigt wie in Fig. 4. In erster Linie ist hier die Unterseite des Gatekopfes nur über ein Breitenmaß c über dem Hohlraum für die parasitären Kapazitäten wirksam und auch diese Wirkung wird durch die horizontale Tiefe b, vorzugsweise b>1,5c, des Hohlraums H1 unter den Spacern 34a und die Abscheidung der Passivierungsschicht mit nur geringer Schichtdicke in dem Hohlraum weiter abgeschwächt. Bei starker Unterätzung können die seitlichen Zusatzschichten auch auf die Projektion unter dem Überhang beschränkt und durch vertikale anisotrope Ätzung erzeugt werden. Während der Erzeugung der Spacer ist die Halbleiteroberfläche durch die Schutzschicht 27 geschützt.

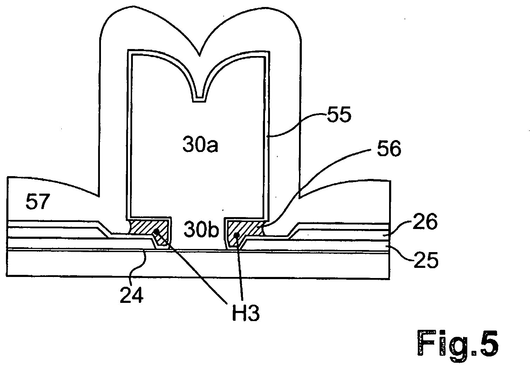

In anderer vorteilhafter Ausführung wird der von Gatekopf, Gatefuß und Recess-Graben mehrseitig umschlossene Hohlraum H1 nicht durch Zuwachsen der Öffnung verschlossen, sondern es wird die Passivierungsschicht 55 wie in Fig. 5 skizziert nur in geringer Dicke aufgewachsen und insbesondere die dem Gatefuß abgewandte Öffnung so weit offen gelassen, dass ein Dielektrikum geringer Elektrizitätskonstante ε, insbesondere ε<3,0, in den Hohlraum H3 unter im wesentlichen vollständiger Füllung desselben eingebracht und dort verfestigt werden kann. Vorzugsweise wird als Dielektrikum BCB gewählt, welches nach Abscheiden der dünnen Passivierungsschicht 55, vorzugsweise Nitrid, flüssig auf die Oberfläche der Anordnung aufgebracht wird und in den Hohlraum eindringt. Das Dielektrikum kann beispielsweise durch Temperatureinwirkung verfestigt werden. Der Abtrag von außerhalb des Hohlraums abgeschiedenen Dielektrikum kann so eingestellt werden, dass das Dielektrikum 56 im Hohlraum weitgehend erhalten bleibt wie in Fig. 5 skizziert.

Vorteilhafterweise kann nach Verfüllung des Hohlraums und, soweit erforderlich, Verfestigung des Dielektrikums 56 im Hohlraum und/oder Entfernen von Dielektrikum außerhalb des Hohlraums, eine weitere Passivierungsschicht 57, welche beispielsweise wiederum Nitrid und/oder Oxid enthält, aufgebracht werden, welche insbesondere das im Hohlraum H3 abgelagerte Dielektrikum in nachfolgenden Prozessen gegen die Einwirkung von Lösungsmitteln und Ätzmitteln schützt.

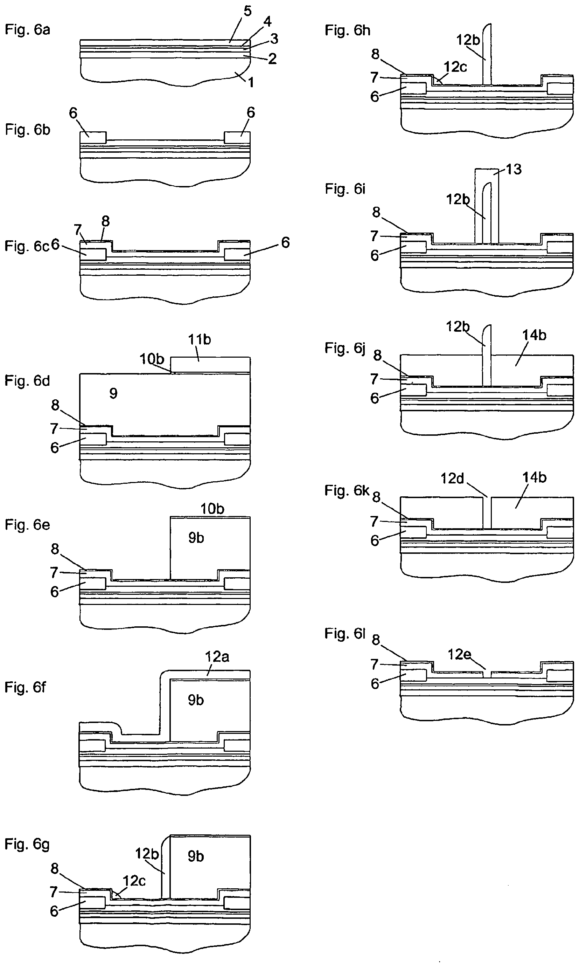

In Fig 6 ist eine bevorzugte Ausführung eines Verfahrensabschnitts zur Definition der Struktur des Elektrodenfußes veranschaulicht. Ausgehend von dem GaAs Substrat 1 stellen die Schichten 2-5 das Vertikalprofil des Transistors dar, das in seiner Dicken- und Elementstruktur von der Anwendung abhängig ist. Grundsätzlich stellt 2 den Buffer dar, 3 bildet das zweidimensionale Elektronengas (den Kanal), 4 ist eine Stopschicht, die zur definierten Ätzung des Recessgrabens beiträgt, und 5 ist eine hochdotierte Kontaktschicht (Fig. 6a). Nach Definition der ohmschen Kontakte 6 in Fig. 6b erfolgt die Abscheidung der Schutzschicht 7 bevorzugt PECVD-Si₃N₄ und das Aufbringen der metallischen Stopschicht 8 (siehe Fig. 6c). Im folgenden wird die temperaturstabile Lackschicht 9 (z. B. PMGI, PMMA oder Polyamid) und die anorganische Schicht 10 aufgebracht, in die durch die Fotolackmaske 11b die Struktur 10b durch Reaktives Ionen Ätzen (RIE) übertragen wird. Die Maske 10b maskiert dann die trockenchemische Plasmaätzung der temperaturstabilen Lackschicht 9 und definiert somit die Struktur 9b, die sich durch eine hohe Flankensteilheit auszeichnet und keinen Lackfuß am Übergang zur Stopschicht 8 aufweist (siehe Fig. 6d und 1e). Beide Eigenschaften lassen sich durch geeignete Parameter der verwendeten RIE Ätzung erzeugen. Nach der Entfernung der Maske 10b erfolgt eine PECVD Abscheidung der Oxidschicht 12a, die durch die nachfolgende anisotrope Ätzung an der Lackkante einen Spacer 12b bildet. Je nach Topographie der ohmschen Kontakte 6 können weitere parasitäre Spacer 12c entstehen (Fig. 6f und 1g). Nach der Entfernung der temperaturstabilen Lackschicht 9 (Fig. 6h), werden durch einen Fotoschritt die Gebiete 13 geschützt, in denen der Oxidspacer erhalten bleiben soll, während die parasitären Spacer entfernt werden. Die Strukturgröße und die Justage von 13 zu 12b sind sehr unkritisch (Fig. 6i).

Eine weitere Lackschicht 14 planarisiert die Oberfläche, und nach einer homogenen trockenchemischen Lackausdünnung verbleibt die rückgeätzte Lackschicht 14b, über welcher der obere Teil des Spacers 12b freigelegt ist (Fig. 6j). Der Spacer kann auch teilweise mit abgetragen werden. Anschließend wird der Spacer selektiv zum Fotolack 14b entfernt, so dass ein Graben 12d im Fotolack entsteht (Fig. 6k), der die anschließende Ätzung der Stopschicht 8 und der Schutzschicht 7 zur Erzeugung der Öffnung 12e maskiert. Nach der Entfernung des verbliebenen Fotolackes 14b ergibt sich die in Fig. 6l gezeigte Situation, an welche sich die aus dem Hauptpatent bekannten Schritte mit ganzflächiger Abscheidung einer Metallschicht, deren Maskierung mit der Struktur für den Elektrodenkopf und Freiätzen der Metallschicht um den Elektrodenkopf bis zur Schutzschicht 7 anschießt.

Die vorstehend und die in den Ansprüchen angegebenen sowie die den Abbildungen entnehmbaren Merkmale sind sowohl einzeln als auch in verschiedener Kombination vorteilhaft realisierbar. Die Erfindung ist nicht auf die beschriebenen Ausführungsbeispiele beschränkt, sondern im Rahmen fachmännischen Könnens in mancherlei Weise abwandelbar. Insbesondere können andere als die im Einzelfall genannten Materialien eingesetzt und abweichende Geometrien gewählt werden.

## Patentansprüche

1. Verfahren zur Herstellung eines Halbleiterbauelementes, bei welchem durch eine Öffnung einer Schutzschicht (27) in einem darunterliegendem Halbleiterbereich (25)ein Recess-Graben (29) und durch die Öffnung der Schutzschicht ein schmaler Elektrodenfuß (30b) und darüber ein breiterer Elektrodenkopf (30a) einer metallischen Elektrode erzeugt wird, wobei das Elektrodenmetall (30) für Elektrodenfuß und Elektrodenkopf ganzflächig durchgehend auf die Schutzschicht (27) und in deren Öffnung (28) abgeschieden und in der Metallschicht (30) die Struktur des Elektrodenkopfes (30a) bis zu der Schutzschicht (27) geätzt wird und danach die Schutzschicht (27) entfernt und ein von Halbleiterbereich, Elektrodenfuß und Elektrodenkopf mehrseitig umgebene und nach einer dem Elektrodenfuß abgewandten Seite anfänglich offener Raum (H1) erzeugt und durch eine danach abgeschiedene Passivierungsschicht (32) die Öffnung des anfänglich offenen Raums (H1) verschlossen und ein verschlossener gasgefüllter Hohlraum (H2) erzeugt wird,
wobei nach Erzeugung des offenen Raums (H1) wenigstens die Halbleiteroberfläche des Recess-Grabens (29) mit der Passivierungsschicht (32) bedeckt wird, und
wobei diese Passivierungsschicht (32) so lange bzw. so dick aufgewachsen wird, dass der anfänglich offene Raum (H1) durch das Material dieser Passivierungsschicht (32) verschlossen wird und der anfänglich offene Raum (H1) einen nicht von Passivierungsmaterial gefüllten Hohlraum als den gasgefüllten Hohlraum (H2) aufweist, wobei das Schichtwachstum der Passivierungsschicht (32) im anfänglich offenen Raum (H1) schwächer als außerhalb des anfänglich offenen Raums (H1) ist.

2. Verfahren nach Anspruch 1, **dadurch gekennzeichnet, dass** die Passivierungsschicht (32) zumindest teilweise aus Nitrid, insbesondere aus Si₃N₄ besteht.

3. Verfahren nach einem der Ansprüche 1 und 2, **dadurch gekennzeichnet, dass** die Passivierungsschicht (32) in einem CVD-Prozess, insbesondere einem PE-CVD Prozess abgeschieden wird.

4. Verfahren nach einem der Ansprüche 1 bis 3, **dadurch gekennzeichnet, dass** der Elektrodenfuß (30b) und/oder der Elektrodenkopf (30a) zumindest überwiegend aus Aluminium hergestellt werden.

5. Verfahren nach einem der Ansprüche 1 bis 4, **dadurch gekennzeichnet, dass** die Passivierungsschicht (32) auch auf der Oberfläche der Elektrode (30a, 30b) abgeschieden wird.

6. Verfahren nach einem der Ansprüche 1 bis 5, **dadurch gekennzeichnet, dass** vor Entfernen der Schutzschicht (27) an den Seitenflanken des Elektrodenkopfes (30a) dielektrische Schichten (34a) abgeschieden werden.

7. Verfahren nach einem der Ansprüche 1 bis 6, **dadurch gekennzeichnet, dass** zur Erzeugung der Öffnung für den Elektrodenfuß auf der Schutzschicht (7) an einer vertikalen Materialkante einer ersten Zwischenschicht (9b) ein Spacer (12b) erzeugt wird, dass um den Spacer eine zweite Zwischenschicht (14b) abgeschieden wird, dass der Spacer aus der zweiten Zwischenschicht entfernt und die dabei in der zweiten Zwischenschicht entstehende Öffnung (12d) als Maske für die Erzeugung der Öffnung (12e) in der Schutzschicht (7, 8) benutzt wird.

8. Verfahren nach Anspruch 7, **dadurch gekennzeichnet, dass** auf der Schutzschicht (7) eine Ätzstopschicht (8) abgeschieden und der Spacer auf dieser Ätzstopschicht erzeugt wird, wobei bei Entfernung des Spacers das Spacermaterial selektiv zu der Ätzstopschicht ätzbar ist.

9. Verfahren nach Anspruch 8, **dadurch gekennzeichnet, dass** als Ätzstopschicht (8) eine Metallschicht abgeschieden wird.

10. Verfahren nach einem der Ansprüche 7 bis 9, **dadurch gekennzeichnet, dass** die erste Zwischenschicht (9b) vor Abscheiden der zweiten Zwischenschicht (14b) entfernt wird.

11. Verfahren nach einem der Ansprüche 7 bis 10, **dadurch gekennzeichnet, dass** die zweite Schicht (14b) von einer anfänglichen Schichtdicke auf eine reduzierte Schichtdicke abgetragen wird, welche geringer ist als die Höhe des Spacers (12b).

12. Verfahren nach einem der Ansprüche 1 bis 11, **dadurch gekennzeichnet, dass** die Ätzung der Struktur des Elektrodenkopfes (30a) derart ausgeführt wird, dass sich der Elektrodenkopf nach unten hin verjüngt.

## Claims

1. Method for producing a semiconductor component, in which a recess trench (29) is produced through an opening in a protective layer (27) in an underlying semiconductor region (25), and a narrow electrode foot (30b) is produced through the opening in the protective layer and a wider electrode head (30a) of a metallic electrode is produced thereabove, wherein the electrode metal (30) for the electrode foot and the electrode head is deposited continuously over the entire surface onto the protective layer (27) and in its opening (28) and the structure of the electrode head (30a) is etched in the metal layer (30) up to the protective layer (27) and thereafter the protective layer (27) is removed and a space (H1) is produced which is initially open toward a side remote from the electrode foot and is surrounded on a plurality of sides by the semiconductor region, electrode foot and electrode head, and the opening of the initially open space (H1) is closed off by a subsequently deposited passivation layer (32) and a closed off, gas-filled cavity (H2) is produced, wherein, after the open space (H1) has been produced, at least the semiconductor surface of the recess trench (29) is covered with the passivation layer (32), and wherein said passivation layer (32) is grown so long or so thick that the initially open space (H1) is closed off by the material of said passivation layer (32) and the initially open space (H1) has a cavity that is not filled with passivation material as the gas-filled cavity (H2), wherein the layer growth of the passivation layer (32) in the initially open space (H1) is weaker than outside the initially open space (H1).

2. Method according to claim 1, **characterized in that** the passivation layer (32) consists at least in part of nitride, in particular of Si₃N₄.

3. Method according to either claim 1 or claim 2, **characterized in that** the passivation layer (32) is deposited in a CVD process, in particular a PE-CVD process.

4. Method according to any of claims 1 to 3, **characterized in that** the electrode foot (30b) and/or the electrode head (30a) are made at least predominantly of aluminum.

5. Method according to any of claims 1 to 4, **characterized in that** the passivation layer (32) is also deposited on the surface of the electrode (30a, 30b).

6. Method according to any of claims 1 to 5, **characterized in that** dielectric layers (34a) are deposited on the side flanks of the electrode head (30a) before removal of the protective layer (27).

7. Method according to any of claims 1 to 6, **characterized in that** a spacer (12b) is produced on a vertical material edge of a first intermediate layer (9b) in order to produce the opening for the electrode foot on the protective layer (7), **in that** a second intermediate layer (14b) is deposited around the spacer, **in that** the spacer is removed from the second intermediate layer and the opening (12d) thus formed in the second intermediate layer is used as a mask for producing the opening (12e) in the protective layer (7, 8).

8. Method according to claim 7, **characterized in that** an etching stop layer (8) is deposited on the protective layer (7) and the spacer is produced on this etching stop layer, it being possible to selectively etch the spacer material relative to the etching stop layer during removal of the spacer.

9. Method according to claim 8, **characterized in that** a metal layer is deposited as an etching stop layer (8).

10. Method according to any of claims 7 to 9, **characterized in that** the first intermediate layer (9b) is removed prior to deposition of the second intermediate layer (14b).

11. Method according to any of claims 7 to 10, **characterized in that** the second layer (14b) is worn down from an initial layer thickness to a reduced layer thickness which is less than the height of the spacer (12b).

12. Method according to any of claims 1 to 11, **characterized in that** the structure of the electrode head (30a) is etched in such a way that the electrode head tapers downward.

## Revendications

1. Procédé de fabrication d'un dispositif semi-conducteur, dans lequel une rainure à évidement (29) est formée par une ouverture d'une couche de protection (27) dans une région semi-conductrice sous-jacente (25) et dans lequel une base d'électrode étroite (30b) et une tête d'électrode élargie (30a) d'une électrode métallique sont formées par l'ouverture de la couche de protection, le métal d'électrode (30) pour la base d'électrode et la tête d'électrode étant déposé entièrement sur toute la surface sur la couche de protection (27) et dans son ouverture (28), et la structure de la tête d'électrode (30a) étant gravée dans la couche métallique (30) jusqu'à la couche de protection (27), la couche de protection (27) étant ensuite enlevée et formant un espace initialement ouvert (H1) entouré sur plusieurs côtés par la région semi-conductrice, la base d'électrode ou la tête d'électrode vers un côté opposé à la base d'électrode, et l'ouverture de l'espace initialement ouvert (H1) étant fermée par une couche de passivation (32) déposée par la suite, permettant ainsi d'obtenir une cavité fermée remplie de gaz (H2),
dans lequel, après la formation de l'espace ouvert (H1), au moins la surface semi-conductrice de la rainure à évidement (29) est recouverte par la couche de passivation (32), et
dans lequel ladite couche de passivation (32) est crûe si longtemps ou à une telle épaisseur que l'espace initialement ouvert (H1) se trouve fermé par le matériau de ladite couche de passivation (32) et l'espace initialement ouvert (H1) présente une cavité non remplie de matériau de passivation autant que la cavité remplie de gaz (H2), la croissance de la couche de passivation (32) dans l'espace initialement ouvert (H1) étant plus faible que hors de l'espace initialement ouvert (H1).

2. Procédé selon la revendication 1, **caractérisé en ce que** la couche de passivation (32) est constituée au moins partiellement de nitrure, en particulier de Si₃N₄.

3. Procédé selon l'une des revendications 1 et 2, **caractérisé en ce que** la couche de passivation (32) est déposée par un procédé CVD, en particulier par un procédé PE-CVD.

4. Procédé selon l'une des revendications 1 à 3, **caractérisé en ce que** la base d'électrode (30b) et/ou la tête d'électrode (30a) sont fabriqués au moins principalement en aluminium.

5. Procédé selon l'une quelconque des revendications 1 à 4, **caractérisé en ce que** la couche de passivation (32) est également déposée sur la surface de l'électrode (30a, 30b).

6. Procédé selon l'une des revendications 1 à 5, **caractérisé en ce que** des couches diélectriques (34a) sont déposées sur les flancs latéraux de la tête d'électrode (30a) avant le retrait de la couche de protection (27).

7. Procédé selon l'une des revendications 1 à 6, **caractérisé en ce qu'**un espaceur (12b) est formé sur un bord vertical du matériau d'une première couche intermédiaire (9b) afin de réaliser l'ouverture pour la base d'électrode sur la couche de protection (7), **en ce qu'**une seconde couche intermédiaire (14b) est déposée autour de l'espaceur, **en ce que** l'espaceur est enlevé de la seconde couche intermédiaire, moyennant quoi l'ouverture (12d) ainsi réalisée dans la seconde couche intermédiaire sert de masque pour la réalisation de l'ouverture (12e) dans la couche de protection (7, 8).

8. Procédé selon la revendication 7, **caractérisé en ce qu'**une couche d'arrêt de gravure (8) est déposée sur la couche de protection (7) et l'espaceur est formé sur cette couche d'arrêt de gravure, le matériau de l'espaceur pouvant être gravé sélectivement par rapport à la couche d'arrêt de gravure lors du retrait de l'espaceur.

9. Procédé selon la revendication 8, **caractérisé en ce qu'**une couche métallique est déposée comme couche d'arrêt de gravure (8).

10. Procédé selon l'une des revendications 7 à 9, **caractérisé en ce que** la première couche intermédiaire (9b) est enlevée avant le dépôt de la seconde couche intermédiaire (14b).

11. Procédé selon l'une des revendications 7 à 10, **caractérisé en ce que** la seconde couche (14b) est enlevée, passant d'une épaisseur de couche initiale à une épaisseur de couche réduite, laquelle est inférieure à la hauteur de l'espaceur (12b).

12. Procédé selon l'une des revendications 1 à 11, **caractérisé en ce que** la gravure de la structure de la tête d'électrode (30a) est effectuée de sorte que la tête d'électrode se rétrécit vers le bas.
